# EUROPEAN PATENT APPLICATION

(11) **EP 3 772 090 A1**
(43) Date of publication of application: **03.02.2021**
(21) Application number: 20188168.7
(22) Date of filing: 28.07.2020
(51) Int. Cl.: H01L 21/683, H01L 23/00, H01L 25/065, H01L 21/56

(54) **METHOD FOR MANUFACTURING AN ELECTRONIC CIRCUIT COMPONENT AND ELECTRONIC CIRCUIT COMPONENT**

(30) Priority: 30.07.2019 DE 102019211371
(71) Applicant: Fraunhofer-Gesellschaft zur Förderung der angewandten Forschung e.V., 80686 München (DE)
(72) Inventor: Ramm, Peter, 80686 München (DE)
(74) Representative: Zinkler, Franz

(57) **Abstract**

What is proposed is a method for manufacturing an electronic circuit component, comprising:
providing a first electronic component with one or several electrically conductive first contacts and with one or several insulating first supporting elements;
providing a second electronic component with one or several electrically conductive second contacts and with one or several insulating second supporting elements;
configuring a connecting structure with an interposer substrate, with electrically conductive third contacts, with one or several electrically conductive fourth contacts, with one or several insulating third supporting elements, with one or several electrically conductive fifth contacts, and with one or several insulating fourth supporting elements;
connecting the first electronic component and the second electronic component to the connecting structure, wherein the first contacts are electrically connected to the fourth contacts, wherein the first supporting elements are mechanically connected to the third supporting elements, wherein the second contacts are electrically connected to the fifth contacts, and wherein the second supporting elements are mechanically connected to the fourth supporting elements, so that the first electronic component, the second electronic component, and the connecting structure are connected electrically and mechanically;
removing a part of the interposer substrate so that the third contacts are exposed.

## Description

The present invention concerns a method for manufacturing three-dimensional electronic circuit components, in particular three-dimensional integrated electronic circuit components. A three-dimensional integration is understood as the vertical mechanical and electric connection of electronic components. Among other things, the advantages of a three-dimensionally integrated electronic circuit component are the higher package densities and switching speeds achievable compared with two-dimensional systems. On the one hand, the latter is due to shorter conduction paths between the individual electronic components and, on the other hand, due to the possibility of processing information in parallel.

With respect to the three-dimensional integration, configuring vertical contacts through the substrate is known. Such through-contacts are called vias. If the substrate is made of silicon, the term through-silicon via, TSV, is usually used.

The so-called 3DIC technology, which is described in the patent US 6,548,351, among other things, is the state of the art in the three-dimensional integration with freely selectable through-silicon vias.

In the 3DIC integration, through-silicon vias are manufactured in the corresponding components in the course of processing. In this case, it is known to manufacture the through-silicon vias after completing the so-called frontend-of-line processes, but before the so-called backend-of-line processes. However, with respect to the production, the 3DIC integration is very complex and cost-intensive.

The so-called 2.5D technology has been established as a more cost-efficient but less powerful integration technology for two or several chips. The corresponding integration technology, which is already used successfully in the mass production, omits through-silicon vias in the components and uses through-silicon via interposers that are used as a vertical rewiring means between horizontally adjacent chips, i.e. which are arranged side-by-side. Processing these through-silicon via interposers is potentially more cost-efficient than the additional production process modules of the 3DIC technologies, however, it is still cost-intensive since it needs very elaborate semiconductor processes, in particular high-resolution lithography, highly anisotropic dry etching processes and complex deposition processes for the insulation and metallization of the through-silicon vias.

Manufacturing and integrating these through-silicon via interposers is too expensive for the majority of the targeted applications.

The invention concerns a method for manufacturing an electronic circuit component, comprising:
providing a first electronic component, wherein one or several first electronic component structures are configured on a first semiconductor substrate, wherein a first rewiring means is configured on a side of the first electronic component structures facing away from the first semiconductor substrate, and wherein one or several electrically conductive first contacts that are electrically connected to the first rewiring means, and one or several insulating first supporting elements are configured on a side of the first rewiring means facing away from the first semiconductor substrate;
providing a second electronic component, wherein one or several second electronic component structures are configured on a second semiconductor substrate, wherein a second rewiring means is configured on a side of the second electronic component structures facing away from the second semiconductor substrate, and wherein one or several electrically conductive second contacts that are electrically connected to the second rewiring means, and one or several insulating second supporting elements are configured on a side of the second rewiring means facing away from the second semiconductor substrate;
configuring a connecting structure, wherein electrically conductive third contacts are configured on a main side of an interposer substrate, wherein a third rewiring means that is electrically connected to the third contacts is configured on a side of the third contacts facing away from the interposer substrate, and wherein one or several electrically conductive fourth contacts that are electrically connected to the third rewiring means, one or several insulating third supporting elements, one or several electrically conductive fifth contacts that are electrically connected to the third rewiring means, and one or several insulating fourth supporting elements are configured on a side of the third rewiring means facing away from the interposer substrate;
connecting the first electronic component and the second electronic component to the connecting structure, wherein the first contacts are electrically connected to the fourth contacts, wherein the first supporting elements are mechanically connected to the third supporting elements, wherein the second contacts are electrically connected to the fifth contacts, and wherein the second supporting elements are mechanically connected to the fourth supporting elements, so that the first electronic component, the second electronic component, and the connecting structure are connected electrically and mechanically;
removing a part of the interposer substrate on a side of the interposer substrate facing away from the third rewiring means so that the third contacts are exposed on a side of the third contacts facing away from the third rewiring means.

In the following, spatial indications refer to an orientation of the first electronic component, the second electronic component, and the connecting structure, according to which they are aligned in parallel to the earth surface, wherein the first and second contacts face downwards and the third contacts face upwards.

The first electronic component and the second electronic component may be configured to be similar or different. For example, the first electronic component may be a processor component, and the second electronic component may be a memory component. Both electronic components may be manufactured by means of known technologies. With an appropriate configuration of the connecting structure, one or several further electronic components may be provided.

In particular, the first semiconductor substrate and the second semiconductor substrate may each consist of silicon.

For example, the first and second contacts may each be manufactured by metal deposition, lithography, and structuring, or by a structured metallization method on the respective rewiring means, and may therefore consist of metal. The first and second supporting elements may consist of an oxide, e.g. silicon oxide.

The first rewiring means may be manufactured by means of known technologies, and may comprise one or several first conductor structures that are each surrounded by a first insulating material. In this case, the first contacts and the first supporting elements may be mechanically connected to the first insulating material.

The second rewiring means may also be manufactured by means of known technologies, and may comprise one or several second conductor structures that are each surrounded by a second insulating material. In this case, the second contacts and the second supporting elements may be mechanically connected to the second insulating material.

The interposer substrate may consist of a semiconductor, in particular silicon, or a non-conductor, e.g. glass.

In particular, the first semiconductor substrate, the second semiconductor substrate, and the interposer substrate may be configured in a plate-shaped manner. Here, the main sides are two opposing sides that each have the largest surface areas.

For example, the third contacts may be manufactured by means of metal deposition, lithography, and structuring, or by a structured metallization method on the interposer substrate, and may therefore consist of metal.

The third rewiring means may also be manufactured by means of known technologies, and may comprise one or several third conductor structures that are each surrounded by a third insulating material.

After configuring the third rewiring means, the third contacts are enclosed between the interposer substrate and the third rewiring means, and are therefore initially not accessible from the outside.

For example, the fourth and fifth contacts may each be manufactured by metal deposition, lithography, and structuring, or by a structured metallization method on the third rewiring means, and may therefore consist of metal. The third and fourth supporting elements may consist of an oxide, e.g. silicon oxide. The fourth and fifths contacts and the third and fourth supporting elements may be mechanically connected to the third insulating material.

Here, a geometrical arrangement of the first contacts and the first supporting elements may correspond to a geometrical arrangement of the fourth contacts and the third supporting elements so that connecting the first contacts to the fourth contacts and connecting the first supporting elements to the third supporting elements may be facilitated.

Similarly, a geometrical arrangement of the second contacts and the second supporting elements may correspond to a geometrical arrangement of the fifth contacts and the fourth supporting elements so that connecting the second contacts to the fifth contacts and connecting the second supporting elements to the fourth supporting elements may be facilitated.

In particular, connecting the first contacts to the fourth contacts, connecting the second contacts to the fifth contacts, connecting the first supporting elements to the third supporting elements, and connecting the second supporting elements to the fourth supporting elements may be performed with appropriate bonding methods.

Connecting the first contacts to the fourth contacts may be carried out such that the first and fourth contacts are flush with respect to each other. Connecting the second contacts to the fifth contacts may be carried out such that the second and fifth contacts are flush with respect to each other. Connecting the first supporting elements to the third supporting elements may be carried out such that the first supporting elements and the third supporting elements are flush with respect to each other. Connecting the second supporting elements to the fourth supporting elements may be carried out such that the second supporting elements and the fourth supporting elements are flush with respect to each other.

The first supporting elements, the second supporting elements, the third supporting elements and the fourth supporting elements may each also be referred to as mechanically-stable contacts.

Removing a part of the interposers substrate, also referred to as thinning, may be performed as a function of the material of the interposers substrate with known methods, and leads to the initially inaccessible third contacts now being accessible from the outside.

Since the first electronic component and the connecting structure are not only connected via the first contacts and the fourth contacts, but also via the first supporting elements and the third supporting elements, and since the second electronic component and the connecting structure are not only connected via the second contacts and the fifth contacts, but also via the second supporting elements and the fourth supporting elements, the electronic component manufactured in such a way is mechanically very stable.

The first supporting elements on the hand and the first insulating material on the other hand may consist of different materials. This makes it possible to optimize the material of the first supporting elements with respect to their support/connection function and to optimize the material of the first insulating material with respect to its insulation function.

The second supporting elements on the hand and the second insulating material on the other hand may consist of different materials. This makes it possible to optimize the material of the second supporting elements with respect to their support/connection function and to optimize the material of the second insulating material with respect to its insulation function.

The third and fourth supporting elements on the hand and the third insulating material on the other hand may consist of different materials. This makes it possible to optimize the material of the third and fourth supporting elements with respect to their support/connection function and to optimize the material of the third insulating material with respect to its insulation function.

In addition, the electronic circuit component manufactured in such a way comprises a three-dimensional structure, however, it does not need elaborate manufacturing of through-contacts in the substrates, such as through-silicon vias. For this reason, manufacturing the electronic circuit components is significantly simplified, while the advantages of the two-dimensional integration are kept, in particular the high package density and the high switching speeds.

According to a preferred further development of the invention, the third contacts are used as a process stop when removing the part of the interposer substrate. To this end, a chemical-mechanical polishing method may be used, e.g., which selectively removes the interposer substrate, but not the third contacts. This further simplifies the method.

According to a preferred further development of the invention, a metal-bonding method is used when connecting the first contacts to the fourth contacts and/or when connecting the second contacts to the fifth contacts. Examples of metal-bonding methods are solid-liquid-interdiffusion bonding, CU-pillar bonding and CU-CU bonding. Such bonding methods are technologically well controllable and simplify the manufacturing method overall.

According to an advantageous further development of the invention, an oxide-bonding method is used when connecting the first supporting elements to the third supporting elements and/or when connecting the second supporting elements to the fourth supporting elements. An example of an oxide-bonding method is oxide-oxide bonding. Such bonding methods are technologically well controllable and therefore simplify the manufacturing method overall.

According to an practical further development of the invention, connecting the first contacts to the fourth contacts and connecting the first supporting elements to the third supporting elements is simultaneously performed by means of a first hybrid-bonding method; and/or wherein connecting the second contacts to the fifth contacts and connecting the second supporting elements to the fourth supporting elements is simultaneously performed by means of a second hybrid-bonding method. For example, CU/oxide-hybrid bonding is suitable to this end. This simplifies the method overall.

According to a practical further development of the invention, prior to connecting the first electronic component to the connecting structure, at least one first adjustment mark is configured at the connecting structure, and at least one second adjustment mark is configured at the first electronic component, wherein the first adjustment mark and the second adjustment mark are used to position the first electronic component and the connecting structure with respect to each other when connecting the first electronic component to the connecting structure.

According to a practical further development of the invention, prior to connecting the second electronic component to the connecting structure, at least one third adjustment mark is configured at the connecting structure, and at least one fourth adjustment mark is configured at the second electronic component, wherein the third adjustment mark and the fourth adjustment mark are used to position the second electronic component and the connecting structure with respect to each other when connecting the second electronic component to the connecting structure.

In this way, positioning the first electronic component and the connecting structure with respect to each other, and/or positioning the second electronic component and the connecting structure with respect to each other may be performed in a precise and simple manner.

According to a practical further development of the invention, in a sectional top view of the electronic circuit component, the first contacts and the first supporting elements are configured such that they are adjacent to each other at least partially without gap.

According to a practical further development of the invention, in a sectional top view of the electronic circuit component, the second contacts and the second supporting elements are configured such that they are adjacent to each other at least partially without gap.

According to a practical further development of the invention, in a sectional top view of the electronic circuit component, the fourth contacts and the third supporting elements are configured such that they are adjacent to each other at least partially without gap.

According to a practical further development of the invention, in a sectional top view of the electronic circuit component, the fifth contacts and the fourth supporting elements are configured such that they are adjacent to each other at least partially without gap.

Due to the at least partially gapless configuration, the package density of the electronic circuit component may be increased.

According to a practical further development of the invention, in a sectional top view of the electronic circuit component, one of the first supporting elements is configured such that it forms a first closed frame structure that frames the first contacts, wherein, in a sectional top view of the electronic circuit component, one of the third supporting elements is configured such that it forms a second closed frame structure that frames the fourth contacts.

According to a practical further development of the invention, in a sectional top view of the electronic circuit component, one of the second supporting elements is configured such that it forms a third closed frame structure that frames the second contacts, wherein, in a sectional top view of the electronic circuit component, one of the fourth supporting elements is configured such that it forms a fourth closed frame structure that frames the fifth contacts.

The closed frame structures increase the robustness of the electronic circuit component. In particular, the corresponding contacts are protected against external influences such as penetrating moisture.

According to a practical further development of the invention, after connecting the first electronic component and the second electronic component to the connecting structure, a cast material layer at least partially covering side faces of the first electronic component and/or side faces of the second electronic component is formed. The cast material layer may be a polymer layer. This further increases the mechanical stability of the electronic circuit component. Preferably, the cast material layer is manufactured prior to partially removing the interposer substrate so that the unfinished electronic circuit component may be handled in a better way during the removal.

According to a preferred further development of the invention, the first electronic component is configured such that limiting faces of the first contacts facing away from the first semiconductor substrate and limiting faces of the first supporting elements facing away from the first semiconductor substrate are in a first mutual plane, wherein the connecting structure is configured such that limiting faces of the fourth contacts facing away from the interposer substrate and limiting faces of the third supporting elements facing away from the interposer substrate are in a second mutual plane.

This further development facilitates connecting the first electronic component to the connecting structure.

According to a preferred further development of the invention, the second electronic component is configured such that limiting faces of the second contacts facing away from the second semiconductor substrate and limiting faces of the second supporting elements facing away from the first semiconductor substrate are in a third mutual plane, wherein the connecting structure is configured such that limiting faces of the fifth contacts facing away from the interposer substrate and limiting faces of the fourth supporting elements facing away from the interposer substrate are in a fourth mutual plane.

This further development facilitates connecting the second electronic component to their connecting structure.

According to a practical further development of the invention, the first rewiring means, the second rewiring means, and/or the third rewiring means is configured by means of a dual-damascene process. This may further simplify the manufacturing method.

According to an advantageous further development of the invention, the first electronic component structures and the first rewiring means of the first electronic component form an integrated circuit.

According to an advantageous further development of the invention, the second electronic component structures and the second rewiring means of the second electronic component form an integrated circuit.

By using integrated circuits, the package density may be further increased.

According to a practical further development of the invention, the first electronic component structures of the first electronic component comprise at least one first passive electronic component and/or at least one first MEMS component.

According to a practical further development of the invention, the second electronic component structures of the second electronic component comprise at least one second passive electronic component and/or at least one second MEMS component.

This broadens the application range of the electronic circuit component and therefore of the manufacturing method.

According to an advantageous further development of the invention, the first electronic component and the second electronic component are configured such that they comprise a same structural height. On the one hand, this facilitates the manageability of the first electronic component and the second electronic component during manufacturing of the electronic circuit components, and, on the other hand, the electronic circuit component may be configured to be more compact.

According to an advantageous further development of the invention, third electronic component structures electrically connected to the third rewiring means is configured in the interposer substrate. This broadens the application range of the electronic circuit component and therefore of the manufacturing method. In addition, the package may not be increased.

According to an advantageous further development of the invention, the third contacts are electrically connected to wiring means of a housing of the electronic circuit component on the side of the third contacts facing away from the third rewiring means. This creates an electronic circuit component with a housing. This may be a standard housing, wherein electric terminals connected to the wiring means are let out of the housing.

According to a preferred further development of the invention, prior to configuring the third contacts, a buried barrier layer is configured in the third substrate, wherein the third contacts are configured such that they contact the buried barrier layer. The buried barrier layer forms a part of the interposer substrate. When exposing the third contacts, it enables to initially remove by means of a selective method the part of the substrate that is on its side facing away from the third contacts, and to then remove the barrier layer itself by means of a further selective method. If the substrate is a semiconductor substrate, the barrier layer may be configured as an oxide layer. If the substrate is an insulated substrate, the barrier layer may be a semiconductor or a polymer.

In a further aspect, the invention concerns an electronic circuit component, comprising:
a first electronic component, wherein one or several first electronic component structures are configured on a first semiconductor substrate of the first electronic component, wherein a first rewiring means is configured on a side of the first electronic component structures facing away from the first semiconductor substrate, wherein one or several electrically conductive first contacts that are electrically connected to the first rewiring means, and one or several insulating first supporting elements are configured on a side of the first rewiring means facing away from the first semiconductor substrate;
a second electronic component, wherein one or several second electronic component structures are configured on a second semiconductor substrate of the second electronic component, wherein a second rewiring means is configured on a side of the second electronic component structures facing away from the second semiconductor substrate, wherein one or several electrically conductive second contacts that are electrically connected to the second rewiring means, and one or several insulating second supporting elements are configured on a side of the second rewiring means facing away from the second semiconductor substrate;
a connecting structure with an interposer substrate, wherein electrically conductive third contacts are configured on a main side of the interposer substrate, wherein a third rewiring means that is electrically connected to the third contacts is configured on a side of the third contacts facing away from the interposer substrate, wherein one or several electrically conductive fourth contacts that are electrically connected to the third rewiring means, one or several insulating third supporting elements, one or several electrically conductive fifth contacts that are electrically connected to the third rewiring means, and one or several insulating fourth supporting elements are configured on a side of the third rewiring means facing away from the interposer substrate;
wherein the first electronic component and the second electronic component are connected to the connecting structure, wherein the first contacts are electrically connected to the fourth contacts, wherein the first supporting elements are mechanically connected to the third supporting elements, wherein the second contacts are electrically connected to the fifth contacts, and wherein the second supporting elements are mechanically connected to the fourth supporting elements, so that the first electronic component, the second electronic component, and the connecting structure are connected electrically and mechanically;
wherein the third contacts are exposed on a side of the third contacts facing away from the third rewiring means by removing a part of the interposer substrate on a side of the interposer substrate facing away from the third rewiring means.

The aforementioned results in the advantages described with respect the method.

In the following, the present invention and its advantages are described in more detail based on the drawings.
- Fig. 1: shows an overview of the method for manufacturing an electronic circuit component;
- Fig. 2: shows an exemplary first electronic component in a sectional schematic side view;
- Fig. 3: shows the exemplary first electronic component of Fig. 2 in a sectional schematic top view;
- Fig. 4: shows an exemplary second electronic component in a sectional schematic side view;
- Fig. 5: shows the exemplary second electronic component of Fig. 4 in a sectional schematic top view;
- Fig. 6: shows an exemplary connecting structure in a sectional schematic side view;
- Fig. 7: shows the exemplary first component of Fig. 2, the exemplary second electronic component of Fig. 4, and the exemplary connecting structure of Fig. 6 prior to connecting them;
- Fig. 8: shows the exemplary first electronic component of Fig. 2, the exemplary second electronic component of Fig. 4, and the exemplary connecting structure of Fig. 6 after connecting them;
- Fig. 9: shows an exemplary electronic circuit component in a sectional schematic side view;
- Fig. 10: shows a further exemplary electronic circuit component in a sectional schematic side view; and
- Fig. 11: shows a further exemplary connecting structure in a sectional schematic side view.

In the following, the same or similar element or elements having the same or equivalent functions are provided with the same or similar reference numerals.

In the following description, embodiments having a multitude of features of the present invention are described in more detail in order to provide a better understanding of the invention. However, it is to be noted that the present invention may also be implemented omitting individual ones of the described features. It is also to be noted that the features shown in different embodiments can be combined in any way if this is not explicitly excluded or would lead to contradictions.

Aspects of the invention described in connection with an apparatus also concern corresponding methods. Vice versa, such aspects of the invention described in connection with a method also concern a corresponding apparatus.

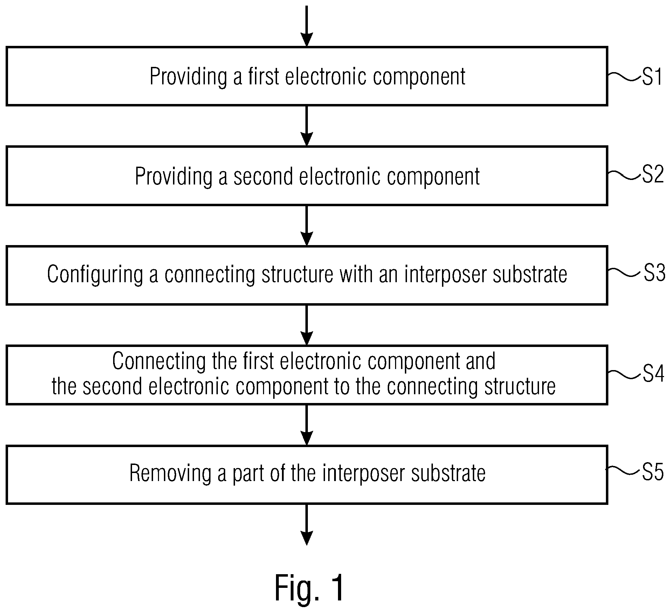

Fig. 1 shows an overview of the method for manufacturing an electronic circuit component 1.

The method for manufacturing an electronic circuit component 1 includes the following steps:
providing S1 a first electronic component 2, wherein one or several first electronic component structures 4 are configured on a first semiconductor substrate 3, wherein a first rewiring means 6 is configured on a side 5 of the first electronic component structures 4 facing away from the first semiconductor substrate 3, and wherein one or several electrically conductive first contacts 8 that are electrically connected to the first rewiring means 6, and one or several insulating first supporting elements 9 are configured on a side 7 of the first rewiring means 6 facing away from the first semiconductor substrate 3;
providing S2 a second electronic component 12, wherein one or several second electronic component structures 14 are configured on a second semiconductor substrate 13, wherein a second rewiring means 16 is configured on a side 15 of the second electronic component structures 14 facing away from the second semiconductor substrate 13, and wherein one or several electrically conductive second contacts 18 that are electrically connected to the second rewiring means 16, and one or several insulating second supporting elements 19 are configured on a side 17 of the second rewiring means 16 facing away from the second semiconductor substrate 13;
configuring S3 a connecting structure 22, wherein electrically conductive third contacts 25 are configured on a main side 23 of an interposer substrate 24, wherein a third rewiring means 27 that is electrically connected to the third contacts 25 is configured on a side 26 of the third contacts 25 facing away from the interposer substrate 24, and wherein one or several electrically conductive fourth contacts 29 that are electrically connected to the third rewiring means 27, one or several insulating third supporting elements 30, one or several electrically conductive fifth contacts 31 that are electrically connected to the third rewiring means 27, and one or several insulating fourth supporting elements 32 are configured on a side 28 of the third rewiring means 27 facing away from the interposer substrate 24;
connecting S4 the first electronic component 2 and the second electronic component 12 to the connecting structure 22, wherein the first contacts 8 are electrically connected to the fourth contacts 29, wherein the first supporting elements 9 are mechanically connected to the third supporting elements 30, wherein the second contacts 18 are electrically connected to the fifth contacts 31, and wherein the second supporting elements 19 are mechanically connected to the fourth supporting elements 32, so that the first electronic component 2, the second electronic component 12, and the connecting structure 22 are connected electrically and mechanically;
removing S5 a part of the interposer substrate 24 on a side 35 of the interposer substrate 24 facing away from the third rewiring means 27 so that the third contacts 25 are exposed on a side 36 of the third contacts 25 facing away from the third rewiring means 27.

Steps S1, S2 and S3 may be performed in any order. However, they are performed prior to steps S4 and S5. In principle, step S5 could be performed prior to step S4. However, it is preferred to perform step S4 prior to step S5, since removing the part of the interposer substrate 24 is facilitated if the interposer substrate 24 is connected to the first electronic component 2 and the second electronic component 12, since the interposer substrate 24 is mechanically stabilized by the first electronic component 2 and the second electronic component 12 in this case.

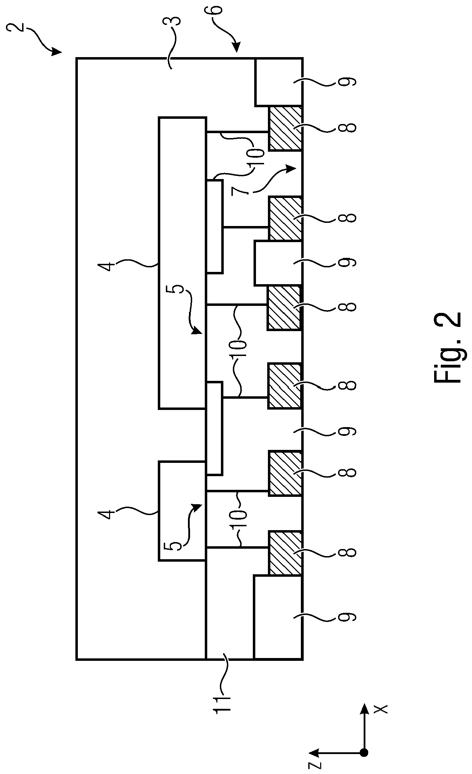

Fig. 2 shows an exemplary first electronic component 2 in a sectional schematic side view.

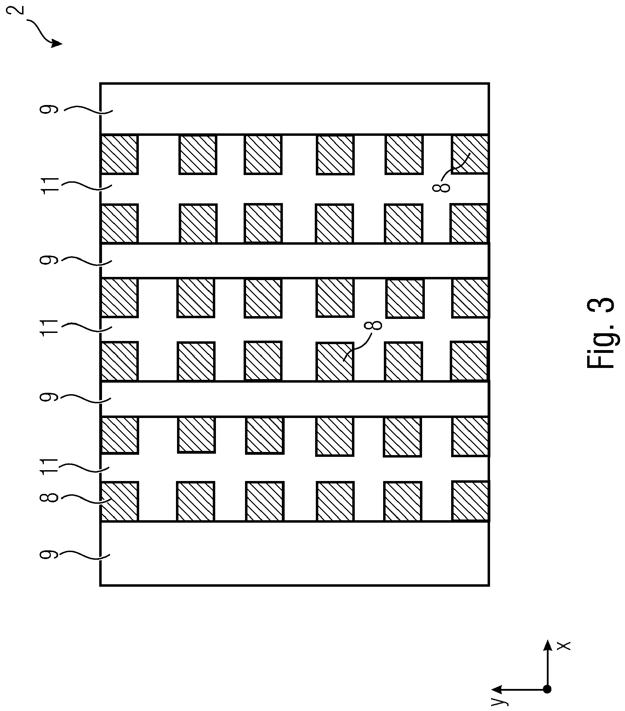

Fig. 3 shows the exemplary first electronic component 2 of Fig. 2 in a sectional schematic top view.

The first electronic component 2 is provided in step S1. In this case, the first electronic component 2 is provided such that one or several first electronic component structures 4 are configured on a first semiconductor substrate 3, such that a first rewiring means 6 is configured on a side 5 of the first electronic component structures 4 facing away from the first semiconductor substrate 3, and such that one or several electrically conductive first contacts 8 that are electrically connected to the first rewiring means 6, and one or several insulating first supporting elements 9 are configured on a side 7 of the first rewiring means 6 facing away from the first semiconductor substrate 3.

The first rewiring means 6 includes a first electric conductor structure 10 that is arranged in a first insulating material 11. The first electric conductor structure 10 may be configured such that it electrically connects different electronic component structures 4, such that it electrically connects different terminals of the same first electronic component structure 4, and/or such that it connects terminals of the first one or several electronic component structures 4 to one of the first contacts 8.

According to an advantageous further development of the invention, in a sectional top view of the electronic circuit component 1, the first contacts 8 and the first supporting elements 9 are configured such that they are adjacent to each other at least partially without gap. Thus, for example, in Fig. 3, the first contacts 8 are each adjacent without gap to one of the first supporting elements 9 on one side.

According to a non-illustrated preferred further development of the invention, in a sectional top view of the electronic circuit component 1, one of the first supporting elements 9 is configured such that it forms a first closed frame structure that frames the first contacts 8, wherein, in a sectional top view of the electronic circuit component 1, one of the third supporting elements 29 is configured such that it forms a second closed frame structure that frames the fourth contacts 29.

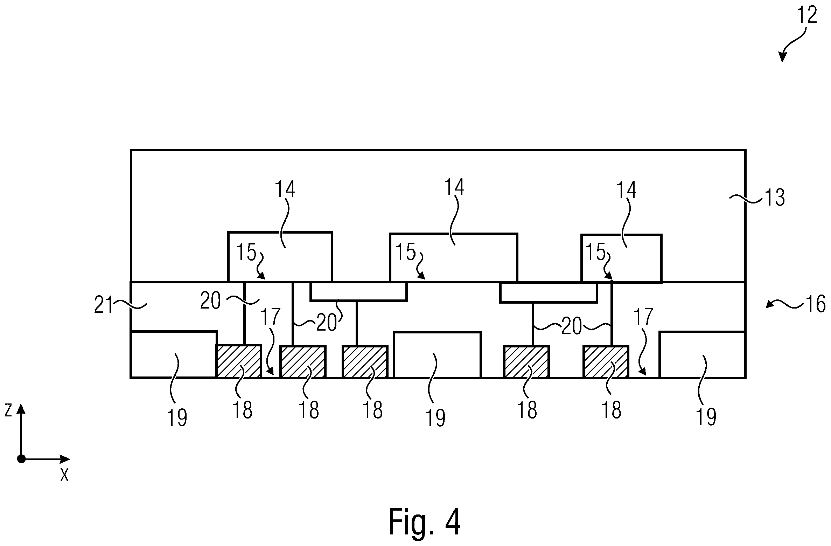

Fig. 4 shows an exemplary second electronic component 12 in a sectional schematic side view.

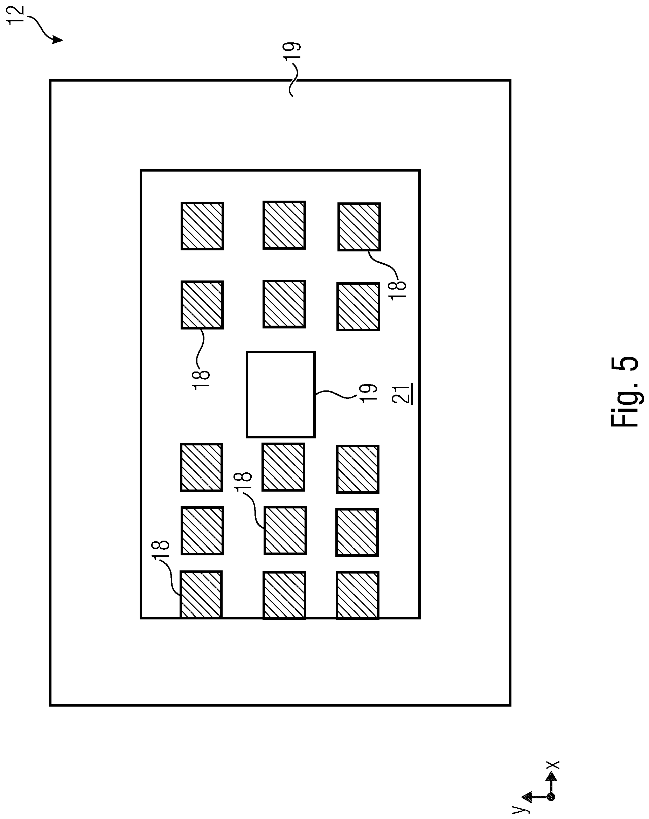

Fig. 5 shows the exemplary second electronic component 12 of Fig. 4 in a sectional schematic top view.

The second electronic component 12 is provided in step S2. In this case, the second electronic component 12 is provided such that one or several second electronic component structures 14 are configured on a second semiconductor substrate 13, such that a second rewiring means 16 is configured on a side 15 of the second electronic component structures 14 facing away from the second semiconductor substrate 13, and such that one or several electrically conductive second contacts 18 that are electrically connected to the second rewiring means 16, and one or several insulating second supporting elements 19 are configured on a side 17 of the second rewiring means 16 facing away from the second semiconductor substrate 13.

The second rewiring means 16 includes a second electric conductor structure 20 that is arranged in a second insulating material 21. The second electric conductor structure 20 may be configured such that it electrically connects different second electronic component structures 14, such that it electrically connects different terminals of the same second electronic component structure 14, and/or such that it connects one or several terminals of the second electronic component structure 4 to one of the second contacts 18.

According to an advantageous further development of the invention, in a sectional top view of the electronic circuit component 1, the second contact 18 and the second supporting element 19 are configured such that they are adjacent to each other at least partially without gap. For example, in Fig. 5, the three left second contacts are each adjacent to the outer second supporting element 19 with their left side without gap.

According to a preferred further development of the invention, in a sectional top view of the electronic circuit component 1, one of the second supporting elements 19 is configured such that it forms a third closed frame structure that frames the second contacts 18, wherein, in a sectional top view of the electronic circuit component 1, one of the fourth supporting elements 32 is configured such that it forms a fourth closed frame structure that frames the fifth contacts 31.

In the embodiment of Fig. 5, a central second supporting element 19 and an outer second supporting element 19 are provided, wherein the outer supporting element 19 forms a third closed frame structure that frames the second contacts 18. The fourth supporting elements 32 are arranged correspondingly.

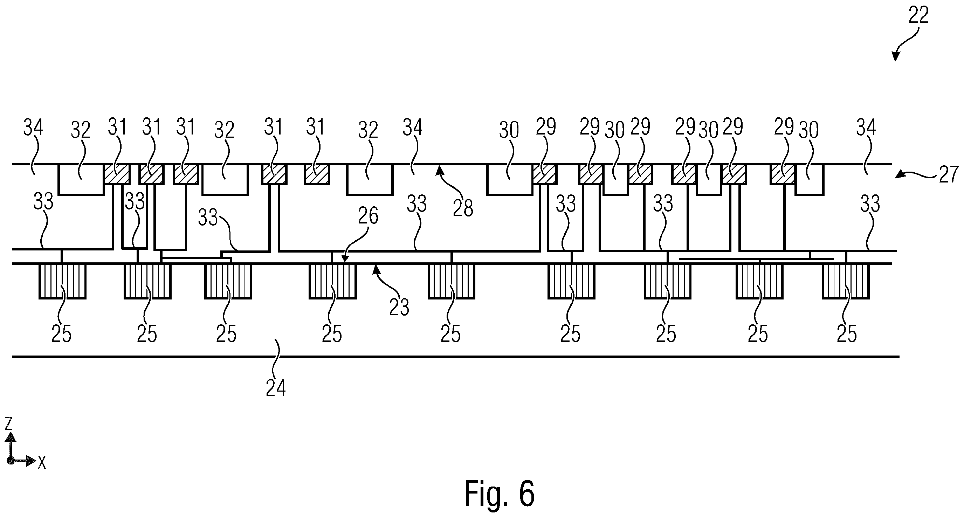

Fig. 6 shows an exemplary connecting structure 22 in a sectional schematic side view.

The connecting structure 22 is configured in step S3, wherein electrically conductive third contacts 25 are configured on a main side 23 of the interposer substrate 24, wherein a third rewiring means 27 that is electrically connected to the third contacts 25 is configured on a side 26 of the third contacts 25 facing away from the interposer substrate 24, and wherein one or several electrically conductive fourth contacts 29 that are electrically connected to the third rewiring means 27, one or several insulating third supporting elements 30, one or several electrically conductive fifth contacts 31 that are electrically connected to the third rewiring means 27, and one or several insulating fourth supporting elements 32 are configured on a side 28 of the third rewiring means 27 facing away from the interposer substrate 24.

The third rewiring means 27 includes a third electric conductive structure 33 that is arranged in a second insulating material 34. The third electric conductive structure 27 may be configured such that it electrically connects one or several of the fourth contacts 29 to one or several of the fifth contacts 31, such that it electrically connects one or several of the third contacts 25 to one or several of the fourth contacts 29, and/or such that it electrically connects one or several of the third contacts 25 to one or several of the fifth contacts 31.

According to a practical further development of the invention, in a sectional top view of the electronic circuit component 1, the fourth contacts 29 and the third supporting elements 30 are configured such that they are adjacent to each other at least partially without gap.

According to a practical further development of the invention, in a sectional top view of the electronic circuit component 1, the fifth contacts 31 and the fourth supporting elements 32 are configured such that they are adjacent to each other at least partially without gap.

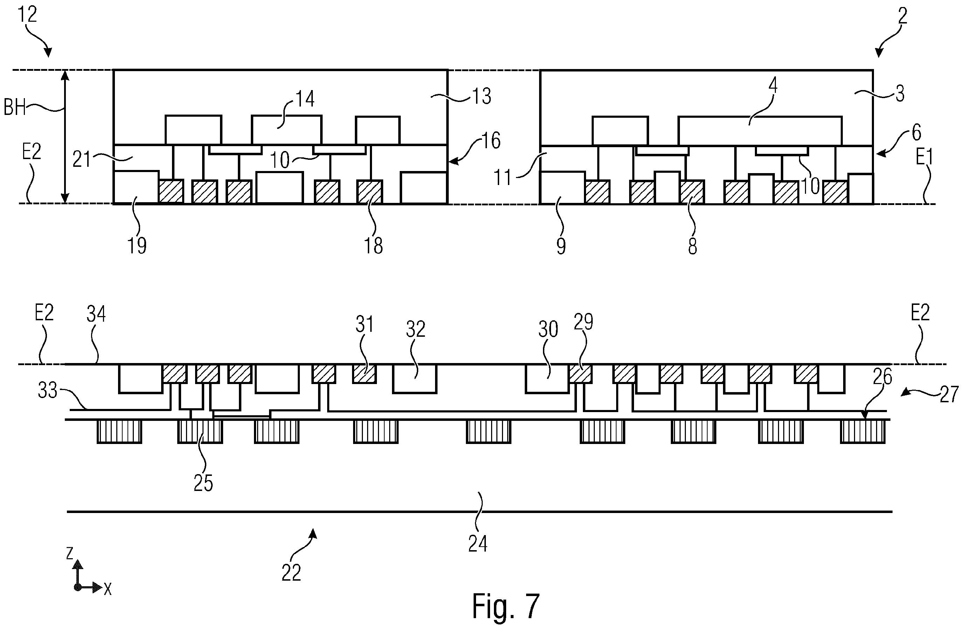

Fig. 7 shows the exemplary first electronic component 2 of Fig. 2, the exemplary second component 12 of Fig. 4, and the exemplary connecting structure 22 of Fig. 6 prior to connecting them.

According to a preferred further development of the invention, the first electronic component 2 is configured such that limiting faces of the first contacts 8 facing away from the first semiconductor substrate 3, and limiting faces of the first supporting elements 9 facing away from the first semiconductor substrate 3 are in a first mutual plane E1, wherein the connecting structure 22 is configured such that limiting faces of the fourth contacts 29 facing away from the interposer substrate 24, and limiting faces of the third supporting elements 30 facing away from the interposer substrate 24 are in a second mutual plane E2.

According to a preferred further development of the invention, the second electronic component 12 is configured such that limiting faces of the second contacts 18 facing away from the second semiconductor substrate 13, and limiting faces of the second supporting elements 19 facing away from the first semiconductor substrate 13 are in a third mutual plane E3, wherein the connecting structure 22 is configured such that limiting faces of the fifth contacts 31 facing away from the interposer substrate 24, and limiting faces of the fourth supporting elements 32 facing away from the interposer substrate 24 are in a fourth mutual plane E4.

According to an advantageous further development of the invention, the first electronic component 2 and the second electronic component 12 are configured such that they comprise a same structural height BH.

According to a practical further development of the invention, prior to connecting S4 the first electronic component 2 to the connecting structure 22, at least one first adjustment mark is configured on the connecting structure 22 and at least one second adjustment mark is configured on the first electronic component 2, wherein, when connecting S4 the first electronic component 2 to the connecting structure 22, the first adjustment mark and the second adjustment mark are used to position the first electronic component 2 and the connecting structure 22 with respect to each other.

According to a practical further development of the invention, prior to connecting S4 the second electronic component 12 to the connecting structure 22, at least one third adjustment mark is configured on the connecting structure 22 and at least one fourth adjustment mark is configured on the second electronic component 12, wherein, when connecting S4 the second electronic component 12 to the connecting structure 22, the third adjustment mark and the fourth adjustment mark are used to position the second electronic component 12 and the connecting structure 22 with respect to each other.

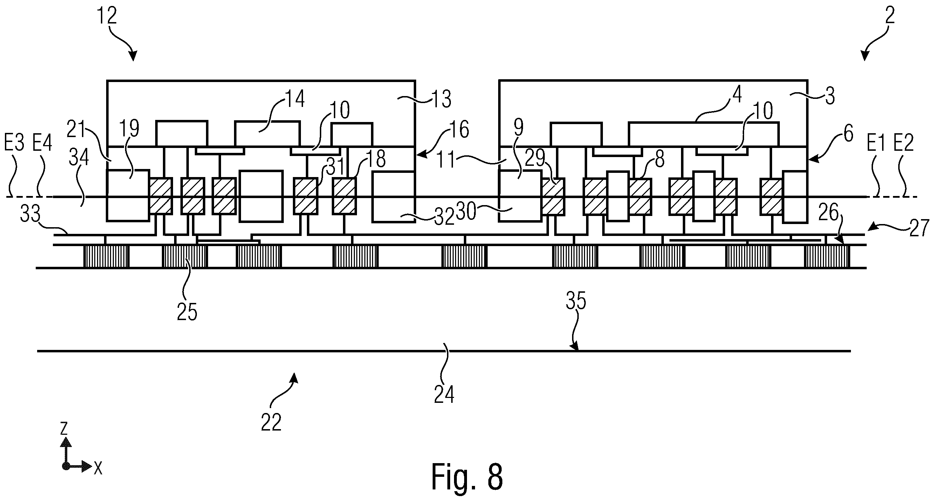

Fig. 8 shows the exemplary first electronic component 2 of Fig. 2, the exemplary second electronic component 12 of Fig. 4, and the exemplary connecting structure 22 of Fig. 6 after connecting them.

Connecting the first electronic component 2 and the second electronic component 12 to the connecting structure 22 is carried out in step S4, wherein the first contacts 8 are electrically connected to the fourth contacts 29, wherein the first supporting elements 9 are mechanically connected to the third supporting elements 30, wherein the second contacts 18 are electrically connected to the fifth contacts 31, and wherein the second supporting elements 19 are mechanically connected to the fourth supporting elements 32, so that the first electronic component 2, the second electronic component 12, and the connecting structure 22 are connected electrically and mechanically.

After connecting the first electronic component 2 to the connecting structure 22, the planes E1 and E2 are in congruence with each other. After connecting the second electronic component 12 to the connecting structure 22, the planes E3 and E4 are in congruence with each other. In the example of Fig. 8, in addition, the planes E1, E2, E3, and E4 are congruent. However, embodiments in which the planes E1 and E2 are not congruent with respect to the planes E3 and D4 are conceivable.

According to a practical further development of the invention, a metal-bonding method is used when connecting S4 the first contacts 8 to the fourth contacts 29 and/or when connecting S4 the second contacts 18 to the fifth contacts 31.

According to an advantageous further development of the invention, an oxide-bonding method is used when connecting S4 the first supporting elements 9 to the third supporting elements 30 and/or when connecting S4 the second supporting elements 19 to the fourth supporting elements 32.

According to a practical further development of the invention, connecting S4 the first contacts 8 to the fourth contacts 29 and connecting the first supporting elements 9 to the third supporting elements 30 is simultaneously performed by means of a first hybrid-bonding method.

According to a practical further development of the invention, connecting the second contacts 18 to the fifth contacts 31 and connecting the second supporting elements 19 to the fourth supporting elements 32 is simultaneously performed by means of a second hybrid-bonding method.

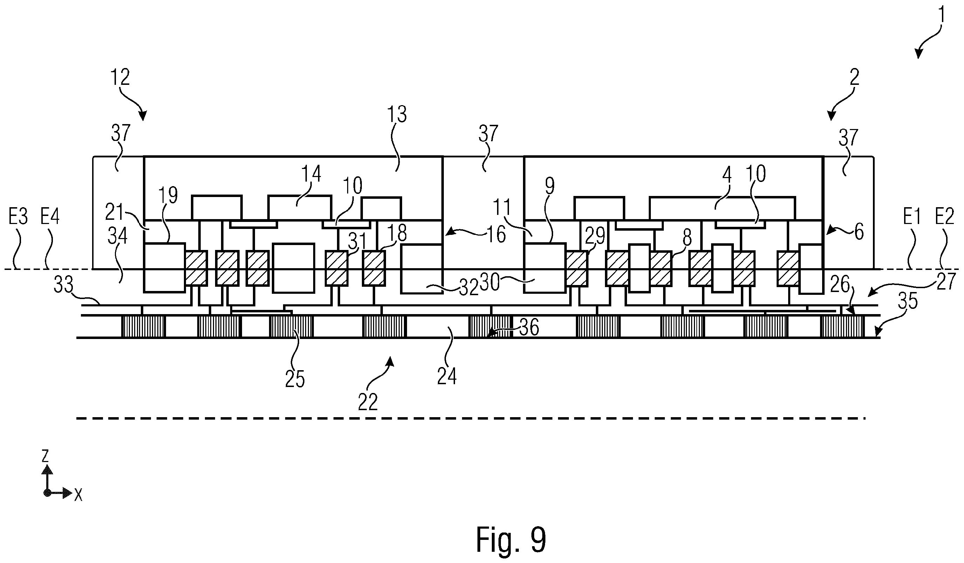

Fig. 9 shows an exemplary electronic circuit component 1 in a sectional schematic side view.

Removing S5 a part of the interposer substrate 24 on a side 35 of the interposer substrate 24 facing away from the third rewiring means 27 is carried out in step S5. The removal is carried out such that the third contacts 25 are exposed on a side 36 of the third contacts 25 facing away from the third rewiring means 27.

In a non-illustrated advantageous further development of the invention, third electronic component structures that are electrically connected to a third rewiring means 27 are configured in the interposer substrate 24.

According to an advantageous further development of the invention, the third contacts 25 are used as a process stop when removing S5 the part of the interposer substrate 24.

According to an advantageous further development of the invention, the first rewiring means 6, the second rewiring means 16, and/or the third rewiring means 27 are configured by means of a dual-damascene process.

According to a practical further development of the invention, the first electronic component structures 4 and the first rewiring means 6 of the first electronic component 2 form an integrated circuit.

According to a practical further development of the invention, the second electronic component structures 14 and the second rewiring means 16 of the second electronic component 12 form an integrated circuit.

According to a non-illustrated practical further development of the invention, the first electronic component structures 4 of the first electronic component 2 comprise at least one first passive electronic component and/or at least one first MEMS component.

According to a non-illustrated practical further development of the invention, the second electronic component structures 14 of the second electronic component 12 comprise at least one second passive electronic component and/or at least one second MEMS component.

According to an advantageous further development of the invention, after connecting S4 the first electronic component 2 and the second electronic component 12 to the connecting structure 22, a cast material layer 37 that at least partially covers side faces of the first electronic component 2 and/or side faces of the second electronic component 12 is configured.

In a further aspect, the invention concerns an electronic circuit component, comprising:
a first electronic component 2, wherein one or several first electronic component structures 4 are configured on a first semiconductor substrate 3 of the first electronic component 2, wherein a first rewiring means 6 is configured on a side 5 of the first electronic component structures 4 facing away from the first semiconductor substrate 3, and wherein one or several electrically conductive first contacts 8 that are electrically connected to the first rewiring means 6, and one or several insulating first supporting elements 9 are configured on a side 7 of the first rewiring means 6 facing away from the first semiconductor substrate 3;
a second electronic component 12, wherein one or several second electronic component structures 14 are configured on a second semiconductor substrate 13 of the second electronic component 12, wherein a second rewiring means 16 is configured on a side 17 of the second electronic component structures 14 facing away from the second semiconductor substrate 13, and wherein one or several electrically conductive second contacts 18 that are electrically connected to the second rewiring means 16, and one or several insulating second supporting elements 19 are configured on a side 17 of the second rewiring means 16 facing away from the second semiconductor substrate 13;
a connecting structure 22 having an interposer substrate 24, wherein electrically conductive third contacts 25 are configured on a main side 23 of the interposer substrate 24, wherein a third rewiring means 27 that is electrically connected to the third contacts 25 is configured on a side 26 of the third contacts 25 facing away from the interposer substrate 24, and wherein one or several electrically conductive fourth contacts 29 that are electrically connected to the third rewiring means 27, one or several insulating third supporting elements 30, one or several electrically conductive fifth contacts 31 that are electrically connected to the third rewiring means 27, and one or several insulating fourth supporting elements 32 are configured on a side 28 of the third rewiring means 27 facing away from the interposer substrate 24;
wherein the first electronic component 2 and the second electronic component 12 are connected to the connecting structure 22, wherein the first contacts 8 are electrically connected to the fourth contacts 29, wherein the first supporting elements 9 are mechanically connected to the third supporting elements 30, wherein the second contacts 18 are electrically connected to the fifth contacts 31, and wherein the second supporting elements 19 are mechanically connected to the fourth supporting elements 32, so that the first electronic component 2, the second electronic component 12, and the connecting structure 22 are connected electrically and mechanically;
wherein the third contacts 25 are exposed on a side 36 of the third contacts 25 facing away from the third rewiring means 27 by removing a part of the interposer substrate 24 on a side 35 of the interposer substrate 24 facing away from the third rewiring means 27.

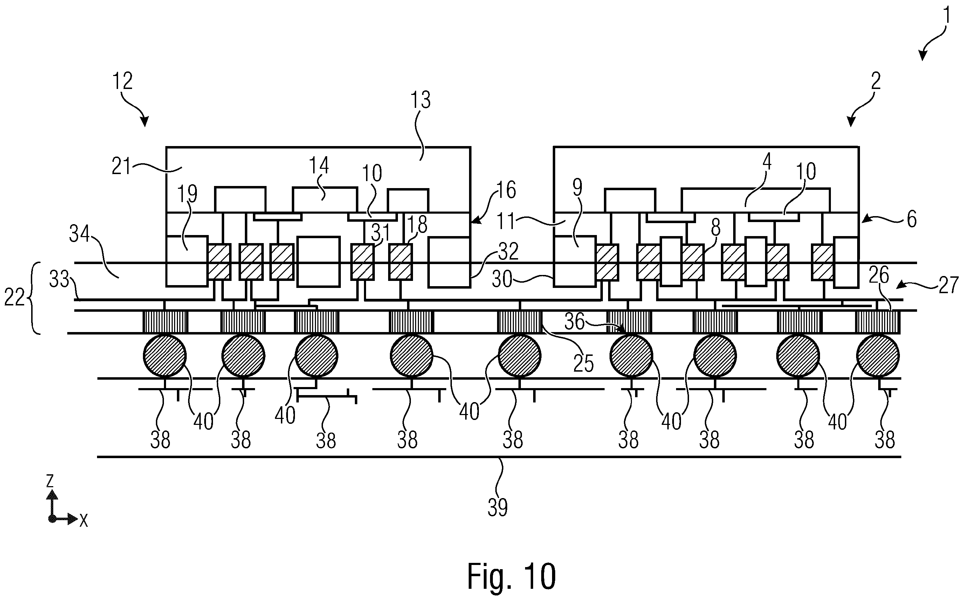

Fig. 10 shows a further exemplary electronic circuit component 1 in a sectional schematic side view.

The embodiment of the electronic circuit component 1 of Fig. 10 is based on the embodiment of Fig. 9, thus, only the differences are described in the following.

According to an advantageous further development of the invention, the third contacts 25 are electrically connected to a wiring means 38 of a housing 39 of the electronic circuit component 1 on the side 36 of the third contacts 25 facing away from the third rewiring means 27.

Fig. 10 only schematically illustrates a bottom side of the housing 39. It is understood that the housing 39 may be a housing 39 that is enclosed on all sides.

Electric connectors 40 are provided to connect the third contacts 25 to the wiring means 38, wherein exactly one electric connector 40 may be provided for each of the third contacts 25. The wiring means 38 may comprise terminals that are led out of the housing 39 in a known manner.

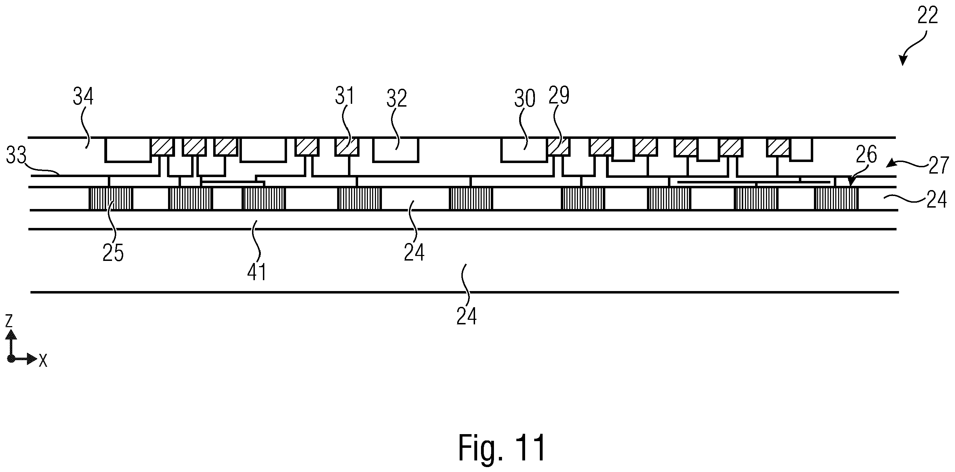

Fig. 11 shows a further exemplary connecting structure 22 in a sectional schematic side view.

The embodiment of the connecting structure 22 is based on the embodiment of Fig. 6, thus, only the differences are described in the following.

According to a preferred further development of the invention, prior to configuring the third contacts 25, a buried barrier layer 41 is configured in the interposer substrate 24, wherein the third contacts 25 are configured such that they contact the buried barrier layer 41.

The buried barrier layer 41 forms a part of the interposer substrate 24. In order to expose the third contacts 25, the buried barrier layer 41 is removed in the same way as the remaining part of the interposer substrate 24 that is located on the side of the buried barrier layer 41 facing away from the third contacts 25.

Embodiments of the invention concern a method for manufacturing three-dimensional electronic systems, wherein a first substrate with a first component (chip 1) and a second substrate with a second component (chip 2) are initially provided. Further chips may be provided, and they may already be three-dimensionally integrated chips.

The chips 1 and 2 are provided with electric contact faces ("contact pads") and mechanical contact faces ("mechanical bond pads") on the respective front side (main surface).

Generally, components are not realized in an interposer, but only surfaces with rewiring means made of structured metal and dielectric layers (redistribution layer) as well as specific faces ("bond pads") for mechanically connecting the first and second substrates on the interposer.

The rewiring means comprise electric contact faces ("electric contact pads"), i.e. specific faces for the vertical electric connection to the component chips 1 and 2. In addition, the interposers comprise "buried" contact faces ("buried contact pads") in the surface areas of the rewiring means.

The interposer may be manufactured as follows: First, the future buried contact pads are processed on the surface of the interposer substrate by means of metal deposition, lithography, and structuring, or by means of a structured metallization method.

What follows is processing the rewiring means and manufacturing the pads for the future mechanical connections as well as the pads for the future electric connections so that the electric contact faces are connected in an electrically conductive manner to the rewiring means, and the buried contacts are ultimately buried in the layer structure.

Advantageously, the two different pad types for the mechanical and electric connection located in different horizontal areas are located approximately in the same structural height (vertically).

In the inventive method, the chips 1 and 2 are adjusted with the main surface in a stacked manner ("chip down") on the interposer substrate and are mechanically and electrically connected to each other using a substrate connection method. In this case, advantageously, the opposing bond pads of the interposer and the chips are used for the precise mechanical connection of the substrate, and the opposing contact pads of the interposer and the chips are used for the high-density vertical electric connection by means of appropriate bonding methods of formed electric connecting structures ("interconnects").

With the three-dimensional mechanical and electric connection of the components via the interposer achieved in such a way, the structured chip-interposer substrate stack may be processed with a mechanical stabilization layer ("mold"). Then - possibly additionally mechanically stabilized by means of the mold layer or appropriate chip-handling methods - the interposer substrate is thinned from its back side until the "buried" contact pads are opened on the bottom side of the interposer substrate. Said contact pad faces (formerly "buried contacts") that are now opened may now be used for the electric connection of this chip-interposer stack to a housing substrate ("package substrate") generally used in the chip assembly, e.g. with the help of a so-called "flip-chip bump" technology.

Thus, the interposer realizes the three-dimensional connection of the chips via the rewiring means and the package substrate.

The method enables the three-dimensional connection of two or several chips in a side-by-side arrangement without the use of cost-intensive through-silicon via technology. A high-integrative rewiring between the chips and the package is achieved with the help of a novel interposer concept that enables a precise horizontally adjustable mechanical connection via bond pads in combination with forming high-density vertical electric interconnects.

### Reference numerals:

- 1: electronic circuit component
- 2: first electronic circuit component
- 3: first semiconductor substrate
- 4: first electronic component structures
- 5: side facing away
- 6: first rewiring means
- 7: side facing away
- 8: first contacts
- 9: first supporting elements
- 10: first conductor structure
- 11: first insulating material
- 12: second electronic component
- 13: second semiconductor substrate
- 14: second electronic components structures
- 15: side facing away
- 16: second rewiring means
- 17: side facing away
- 18: second contacts
- 19: second supporting elements
- 20: second conductor structure
- 21: second insulating material
- 22: connecting structure
- 23: main side
- 24: interposer substrate
- 25: third contacts
- 26: side facing away
- 27: third rewiring means
- 28: side facing away
- 29: fourth contacts
- 30: third supporting elements
- 31: fifth contacts
- 32: fourth supporting elements
- 33: third conductor structure
- 34: third insulating material
- 35: side facing away
- 36: side facing away
- 37: cast material layer
- 38: wiring means
- 39: housing
- 40: electric connector
- 41: barrier layer

- S1: first step
- S2: second step
- S3: third step
- S4: fourth step
- S5: fifth step
- E1: first plane
- E2: second plane
- E3: third plane
- E4: fourth plane
- BH: structural height

## Claims

1. Method for manufacturing an electronic circuit component (1), comprising:
providing (S1) a first electronic component (2), wherein one or several first electronic component structures (4) are configured on a first semiconductor substrate (3), wherein a first rewiring means (6) is configured on a side (5) of the first electronic component structures (4) facing away from the first semiconductor substrate (3), and wherein one or several electrically conductive first contacts (8) that are electrically connected to the first rewiring means (6), and one or several insulating first supporting elements (9) are configured on a side (7) of the first rewiring means (6) facing away from the first semiconductor substrate (3);
providing (S2) a second electronic component (12), wherein one or several second electronic component structures (14) are configured on a second semiconductor substrate (13), wherein a second rewiring means (16) is configured on a side (15) of the second electronic component structures (14) facing away from the second semiconductor substrate (13), and wherein one or several electrically conductive second contacts (18) that are electrically connected to the second rewiring means (16), and one or several insulating second supporting elements (19) are configured on a side (17) of the second rewiring means (16) facing away from the second semiconductor substrate (13);
configuring (S3) a connecting structure (22), wherein electrically conductive third contacts (25) are configured on a main side (23) of an interposer substrate (24), wherein a third rewiring means (27) that is electrically connected to the third contacts (25) is configured on a side (26) of the third contacts (25) facing away from the interposer substrate (24), and wherein one or several electrically conductive fourth contacts (29) that are electrically connected to the third rewiring means (27), one or several insulating third supporting elements (30), one or several electrically conductive fifth contacts (31) that are electrically connected to the third rewiring means (27), and one or several insulating fourth supporting elements (32) are configured on a side (28) of the third rewiring means (27) facing away from the interposer substrate (24);
connecting (S4) the first electronic component (2) and the second electronic component (12) to the connecting structure (22), wherein the first contacts (8) are electrically connected to the fourth contacts (29), wherein the first supporting elements (9) are mechanically connected to the third supporting elements (30), wherein the second contacts (18) are electrically connected to the fifth contacts (31), and wherein the second supporting elements (19) are mechanically connected to the fourth supporting elements (32), so that the first electronic component (2), the second electronic component (12), and the connecting structure (22) are connected electrically and mechanically;
removing (S5) a part of the interposer substrate (24) on a side (35) of the interposer substrate (24) facing away from the third rewiring means (27) so that the third contacts (25) are exposed on a side (36) of the third contacts (25) facing away from the third rewiring means (27).

2. Method according to the preceding claim, wherein the third contacts (25) are used as a process stop when removing (S5) the part of the interposer substrate (24).

3. Method according to any one of the preceding claims, wherein a metal-bonding method is used when connecting (S4) the first contacts (8) to the fourth contacts (29) and/or when connecting (S4) the second contacts (18) to the fifth contacts (31).

4. Method according to any one of the preceding claims, wherein an oxide-bonding method is used when connecting (S4) the first supporting elements (9) to the third supporting elements (30) and/or when connecting (S4) the second supporting elements (19) to the fourth supporting elements (32).

5. Method according to any one of the preceding claims, wherein connecting (S4) the first contacts (8) to the fourth contacts (29) and connecting the first supporting elements (9) to the third supporting elements (30) is simultaneously performed by means of a first hybrid-bonding method;
wherein connecting the second contacts (18) to the fifth contacts (31) and connecting the second supporting elements (19) to the fourth supporting elements (32) is simultaneously performed by means of a second hybrid-bonding method.

6. Method according to any one of the preceding claims, wherein, prior to connecting (S4) the first electronic component (2) to the connecting structure (22), at least one first adjustment mark is configured on the connecting structure (22) and at least one second adjustment mark is configured on the first electronic component (2), wherein, when connecting (S4) the first electronic component (2) to the connecting structure (22), the first adjustment mark and the second adjustment mark are used to position the first electronic component (2) and the connecting structure (22) with respect to each other;
and/or
wherein, prior to connecting (S4) the second electronic component (12) to the connecting structure (22), at least one third adjustment mark is configured on the connecting structure (22) and at least one fourth adjustment mark is configured on the second electronic component (12), wherein, when connecting (S4) the second electronic component (12) to the connecting structure (22), the third adjustment mark and the fourth adjustment mark are used to position the second electronic component (12) and the connecting structure (22) with respect to each other.

7. Method according to any one of the preceding claims, wherein, in a sectional top view of the electronic circuit component (1), the first contacts (8) and the first supporting elements (9) are configured such that they are adjacent to each other at least partially without gap;
and/or
wherein, in a sectional top view of the electronic circuit component (1), the second contact (18) and the second supporting element (19) are configured such that they are adjacent to each other at least partially without gap.

8. Method according to any one of the preceding claims, wherein, in a sectional top view of the electronic circuit component (1), the fourth contacts (29) and the third supporting elements (30) are configured such that they are adjacent to each other at least partially without gap;
and/or
wherein, in a sectional top view of the electronic circuit component (1), the fifth contacts (31) and the fourth supporting elements (32) are configured such that they are adjacent to each other at least partially without gap.

9. Method according to any one of the preceding claims, wherein, in a sectional top view of the electronic circuit component (1), one of the first supporting elements (9) is configured such that it forms a first closed frame structure that frames the first contacts (8), wherein, in a sectional top view of the electronic circuit component (1), one of the third supporting elements (29) is configured such that it forms a second closed frame structure that frames the fourth contacts (29);
and/or
wherein, in a sectional top view of the electronic circuit component (1), one of the second supporting elements (19) is configured such that it forms a third closed frame structure that frames the second contacts (18), wherein, in a sectional top view of the electronic circuit component (1), one of the fourth supporting elements (32) is configured such that it forms a fourth closed frame structure that frames the fifth contacts (31).

10. Method according to any one of the preceding claims, wherein, after connecting (S4) the first electronic component (2) and the second electronic component (12) to the connecting structure (22), a cast material layer (37) that at least partially covers side faces of the first electronic component (2) and/or side faces of the second electronic component (12) is configured.

11. Method according to any one of the preceding claims, wherein the first electronic component (2) is configured such that limiting faces of the first contacts (8) facing away from the first semiconductor substrate (3), and limiting faces of the first supporting elements (9) facing away from the first semiconductor substrate (3) are in a first mutual plane (E1), wherein the connecting structure (22) is configured such that limiting faces of the fourth contacts (29) facing away from the interposer substrate (24), and limiting faces of the third supporting elements (30) facing away from the interposer substrate (24) are in a second mutual plane (E2);
and/or
wherein the second electronic component (12) is configured such that limiting faces of the second contacts (18) facing away from the second semiconductor substrate (13), and limiting faces of the second supporting elements (19) facing away from the first semiconductor substrate (13) are in a third mutual plane (E3), wherein the connecting structure (22) is configured such that limiting faces of the fifth contacts (31) facing away from the interposer substrate (24), and limiting faces of the fourth supporting elements (32) facing away from the interposer substrate (24) are in a fourth mutual plane (E4).

12. Method according to any one of the preceding claims, wherein the first rewiring means (6), the second rewiring means (16), and/or the third rewiring means (27) are configured by means of a dual-damascene process.

13. Method according to any one of the preceding claims, wherein the first electronic component structures (4) and the first rewiring means (6) of the first electronic component (2) form an integrated circuit.;
and/or
wherein the second electronic component structures (14) and the second rewiring means (16) of the second electronic component (12) form an integrated circuit.

14. Method according to any one of the preceding claims, wherein the first electronic component structures (4) of the first electronic component (2) comprise at least one first passive electronic component and/or at least one first MEMS component;
and/or
wherein the second electronic component structures (14) of the second electronic component (12) comprise at least one second passive electronic component and/or at least one second MEMS component.

15. Method according to any one of the preceding claims, wherein the first electronic component (2) and the second electronic component (12) are configured such that they comprise a same structural height (BH).

16. Method according to any one of the preceding claims, wherein third electronic component structures that are electrically connected to a third rewiring means (27) are configured in the interposer substrate (24).

17. Method according to any one of the preceding claims, wherein the third contacts (25) are electrically connected to a wiring means (38) of a housing (39) of the electronic circuit component (1) on the side (36) of the third contacts (25) facing away from the third rewiring means (27).

18. Method according to any one of the preceding claims, wherein, prior to configuring the third contacts (25), a buried barrier layer (41) is configured in the interposer substrate (24), wherein the third contacts (25) are configured such that they contact the buried barrier layer (41).

19. Electronic circuit component, comprising:
a first electronic component (2), wherein one or several first electronic component structures (4) are configured on a first semiconductor substrate (3) of the first electronic component (2), wherein a first rewiring means (6) is configured on a side (5) of the first electronic component structures (4) facing away from the first semiconductor substrate (3), and wherein one or several electrically conductive first contacts (8) that are electrically connected to the first rewiring means (6), and one or several insulating first supporting elements (9) are configured on a side (7) of the first rewiring means (6) facing away from the first semiconductor substrate (3);
a second electronic component (12), wherein one or several second electronic component structures (14) are configured on a second semiconductor substrate (13) of the second electronic component (12), wherein a second rewiring means (16) is configured on a side (17) of the second electronic component structures (14) facing away from the second semiconductor substrate (13), and wherein one or several electrically conductive second contacts (18) that are electrically connected to the second rewiring means (16), and one or several insulating second supporting elements (19) are configured on a side (17) of the second rewiring means (16) facing away from the second semiconductor substrate (13);
a connecting structure (22) having an interposer substrate (24), wherein electrically conductive third contacts (25) are configured on a main side (23) of the interposer substrate (24), wherein a third rewiring means (27) that is electrically connected to the third contacts (25) is configured on a side (26) of the third contacts (25) facing away from the interposer substrate (24), and wherein one or several electrically conductive fourth contacts (29) that are electrically connected to the third rewiring means (27), one or several insulating third supporting elements (30), one or several electrically conductive fifth contacts (31) that are electrically connected to the third rewiring means (27), and one or several insulating fourth supporting elements (32) are configured on a side (28) of the third rewiring means (27) facing away from the interposer substrate (24);
wherein the first electronic component (2) and the second electronic component (12) are connected to the connecting structure (22), wherein the first contacts (8) are electrically connected to the fourth contacts (29), wherein the first supporting elements (9) are mechanically connected to the third supporting elements (30), wherein the second contacts (18) are electrically connected to the fifth contacts (31), and wherein the second supporting elements (19) are mechanically connected to the fourth supporting elements (32), so that the first electronic component (2), the second electronic component (12), and the connecting structure (22) are connected electrically and mechanically;
wherein the third contacts (25) are exposed on a side (36) of the third contacts (25) facing away from the third rewiring means (27) by removing a part of the interposer substrate (24) on a side (35) of the interposer substrate (24) facing away from the third rewiring means (27).
